# EUROPEAN PATENT APPLICATION

(11) **EP 1 655 269 A1**
(43) Date of publication of application: **10.05.2006**
(21) Application number: 04722391.2
(22) Date of filing: 22.03.2004
(51) Int. Cl.: C03B 11/00, B81C 1/00

(54) **METHOD OF FABRICATING MOLD FOR GLASS PRESS**

(30) Priority: 22.05.2003 JP 2003144363
(71) Applicant: Japan Science and Technology Corporation, Kawaguchi-shi, Saitama 332-0012 (JP)
(72) Inventor: TANAKA, Shuji, 206, 4-22, Hachiman 1-chome, Miyagi 980-0871 (JP); ESASHI, Masayoshi, 11-9,Yagiyama-minami 1-chome, Sendai-shi, Miyagi 982-0807 (JP)
(74) Representative: Calamita, Roberto
(86) International application number: PCT/JP2004/003861
(87) International publication number: WO 2004/103920

(57) **Abstract**

A method of fabricating a mold for glass press, **characterized in that** silicon carbide is deposited on the surface of a silicon mold, subsequently the deposited silicon carbide is bonded to a silicon carbide substrate, and thereafter the silicon mold is removed by etching. In this method of fabricating a mold for glass press, the bonding between the silicon carbide deposited on the silicon mold surface and the silicon carbide substrate can be strengthened by interposing a metal thin film.

## Description

### Technical Field

The present invention relates to a method of fabricating a mold for glass press. More specifically, the present invention relates to a method of fabricating a mold for glass press, capable of fabricating a mold for glass press having a minute structure with an extremely small surface roughness.

### Background Art

Glass has the excellent characteristics in terms of the optical characteristic, the temperature stability, the endurance, or the like. Therefore, a high performance optical part is made of a glass. Since the glass press for mass production of the glass optical parts is carried out at a high temperature of for example 800°C or higher, a super hard material and a silicon carbide, having the excellent high temperature strength and chemical stability, can be presented as the candidates for a mold material. However, since the super hard material and the silicon carbide can hardly be processed, they can be processed in generally only by grinding. Moreover, although grinding is applied for processing a spherical surface or a non-spherical surface of a certain size, it is not suited for formation of a minute structure due to the problems of the tool size, wear, or the like.

On the other hand, as a molding method of resin, a method of forming a minute structure in a silicon by photolithography and etching and transferring by hot press, injection molding, or the like, using the same as a mold is known. However, since a silicon creeps at 600°C or higher and it has a high reactivity, it is not suited for glass press mold material.

The present inventor has already proposed a method of fabricating a minute structure of a silicon carbide (Japanese Patent Application Laid-Open No. 2001-139377). However, since the minute structure of a silicon carbide fabricated by the method has a rough surface, it cannot be used for a mold of a glass optical part.

The present invention has been achieved in view of the circumstances, and an object thereof is to provide a method of fabricating a mold for glass press, capable of fabricating a mold for glass press having a minute structure with an extremely small surface roughness.

In order to solve the above-mentioned problems, the present invention firstly provides a method of fabricating a mold for glass press, characterized in that a silicon carbide is deposited on the surface of a silicon mold, subsequently the deposited silicon carbide is bonded to a silicon carbide substrate, and thereafter the silicon mold is removed by etching.

The present invention secondly provides the above-mentioned first method of fabricating a mold for glass press, characterized in that a metal thin film is interposed between the silicon carbide deposited on the surface of the silicon mold and the silicon carbide substrate.

### Brief Description of Drawings

FIGS. 1<a><b><c><d><e><f> are process cross sectional diagrams each schematically showing a method of fabricating a mold for glass press according to the present invention.
FIG. 2 is a microscopic image of the surface of a silicon carbide mold obtained in the example.
FIG 3 is a microscopic image showing the state of pressing a glass by the silicon carbide mold obtained in the example.

### Best Mode for Carrying Out the Invention

Hereinafter, a method of fabricating a mold for glass press of the present invention will be explained in further detail with reference to the drawings.

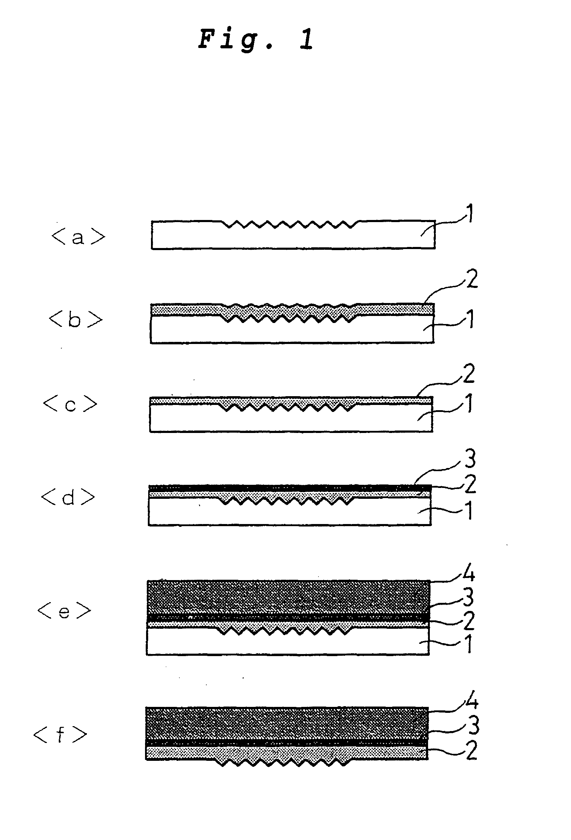

As shown in FIG. 1<a>, a silicon mold (1) is prepared. The silicon mold (1) can be obtained by for example fabricating a minute structure on a single crystal silicon by photolithography, etching, or the like so as to provide a female mold. At the time of fabricating the silicon mold (1), by applying an IC processing technique, minute process is possible with a high resolution and a high accuracy, and furthermore, a high freedom.

Then, as shown in FIG. 1 <b>, according to the method of fabricating a mold for glass press of the present invention, a silicon carbide (SiC) (2) is deposited on the silicon mold (1). For the silicon carbide (2) deposition, a chemical vapor deposition (CVD) can be used.

As shown in FIG. 1 <c>, the deposited silicon carbide (2) can be flattened by polishing the surface. It is effective for improving the bonding property to a silicon carbide substrate.

Moreover, according to the method of fabricating a mold for glass press of the present invention, as shown in FIG 1 <d>, a metal thin film (3) can be formed on the surface of the silicon carbide (2) by sputtering, or the like. The metal thin film (3) is to function as a bonding layer to the silicon carbide substrate, and it is effective for improving the bonding property. The material of the metal thin film (3) is not particularly limited, and it can be selected optionally. Moreover, the metal thin film (3) can be omitted.

Then, as shown in FIG 1 <e>, the silicon carbide substrate (4) is bonded to the deposited silicon carbide (2). The bonding operation can be carried out by solid phase bonding. In the case where the metal thin film (3) is formed on the surface of the silicon carbide (2) as shown in FIG 1 <d>, the metal thin film (3) is a bonding layer between the silicon carbide (2) and the silicon carbide substrate (4).

Finally, according to the method of fabricating a mold for glass press, as shown in FIG. 1 <f>, the silicon mold (1) is removed by etching. For the etching operation, various kinds of solutions, or the like can be used. For example, a liquid mixture of a hydrofluoric acid and a nitric acid, or the like can be presented.

Accordingly, a silicon carbide mold is fabricated with the minute structure which is formed in the silicon mold (1) and transferred accurately to the mold surface. The surface roughness is extremely small. A mold for glass press can be fabricated.

### Example

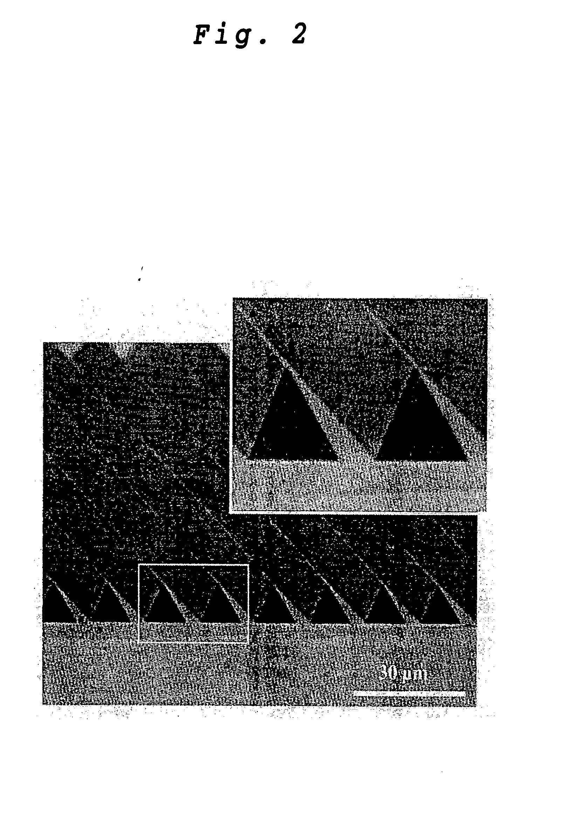

A silicon carbide was deposited by a 50 µm thickness on a silicon mold with a plurality of minute triangular grooves formed adjacently and parallel with each other on the surface by the atmospheric pressure CVD. Then, a 500 µm thickness silicon carbide substrate was bonded to the silicon carbide via a 0.5 µm thickness nickel thin film. The bonding conditions were 900°C and 0.5 hour. Thereafter, the silicon mold was etched by a liquid mixture of a hydrofluoric acid and a nitric acid. The fabricated silicon carbide mold was as shown in FIG. 2, with a plurality of triangular prisms matching the triangular grooves of the silicon mold formed adjacently and parallel with each other on the surface. The surface roughness of the silicon carbide mold was 0.004 to 0.008 µm Ra, and thus it is a mold to be used sufficiently for fabrication of a glass optical part.

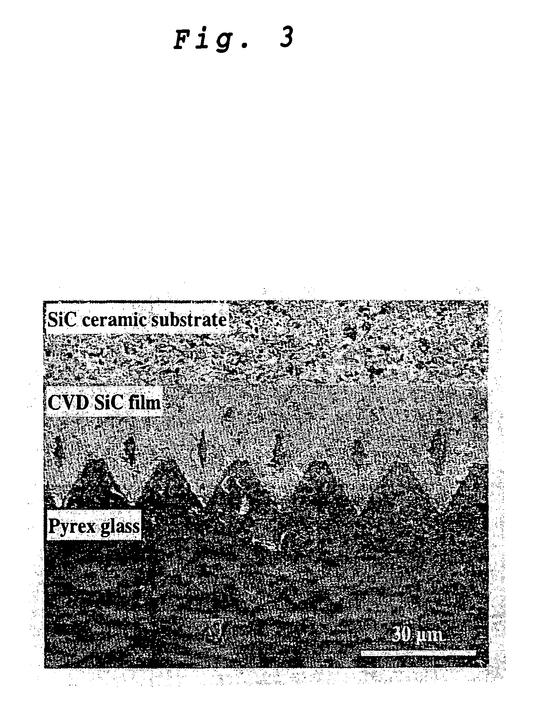

Actually, in a hot press device, the obtained silicon carbide mold was used for pressing a 1 mm thickness Pyrex (registered trademark) glass with the 850°C, 1 MPa conditions. As shown in FIG 3, the Pyrex (registered trademark) glass was shaped by the silicon carbide mold without generating a void or damaging the silicon carbide.

Of course the present invention is not limited by the above-mentioned embodiments or example. It is needless to say that various embodiments can be adopted for the details such as the structure of forming on the silicon mold surface, the silicon carbide depositing conditions, the bonding conditions for the deposited silicon carbide to the silicon carbide substrate, or the like.

### Industrial Applicability

As heretofore explained in detail, according to the present invention, a mold for glass press having a minute structure with an extremely small surface roughness can be fabricated. A glass optical element, which has been fabricated by photolithography and etching so far can be fabricated by press shaping. Moreover, the high performance and the high function of the optical element can be expected so that a complicated optical system is expected to be substituted by one glass optical element.

## Claims

1. A method of fabricating a mold for glass press, **characterized in that** a silicon carbide is deposited on the surface of a silicon mold, subsequently the deposited silicon carbide is bonded to a silicon carbide substrate, and thereafter the silicon mold is removed by etching.

2. The method of fabricating a mold for glass press according to claim 1, wherein a metal thin film is interposed between the silicon carbide deposited on the surface of the silicon mold and the silicon carbide substrate.
